# FASCICULE DE BREVET EUROPEEN

(11) **EP 0 468 863 B1**
(45) Date de publication et mention de la délivrance du brevet: **11.05.1994**
(21) Numéro de dépôt: 91402013.6
(22) Date de dépôt: 18.07.1991
(51) Int. Cl.: H01L 21/00

(54) **Etuve de déverminage de modules électroniques**
Einbrennungsofen für elektronische Module
Burn-in kiln for electronic modules

(30) Priorité: 23.07.1990 FR 9009389
(43) Date de publication de la demande: 29.01.1992
(73) Titulaire: FROILABO Société Anonyme, F-77834 Ozoir La Ferrière (FR)
(72) Inventeur: Laine, Bernard, F-94130 Nogent sur Marne (FR)
(74) Mandataire: Rodhain, Claude

(56) Documents cités:
- EP-A- 0 314 481
- IBM TECHNICAL DISCLOSURE BULLETIN. vol. 9, no. 3, août 1966, NEW YORK US page 342 R.C. CHU: "Thermoelectric cooling for memory arrays"

## Description

La présente invention concerne une étuve permettant d'effectuer le déverminage ou *burn-in* de modules électroniques, c'est-à-dire l'opération consistant à faire fonctionner pendant un temps suffisant un lot de ces modules électroniques pour en éliminer ceux qui présentent des défaillances précoces.

Ce déverminage est réalisé sous contrainte thermique, de manière à faire fonctionner les modules dans leurs conditions extrêmes de température de jonction, soit à température constante, soit en suivant des cycles thermiques prédéterminés.

Une étuve de déverminage d'un composant électronique est decrite dans EP-A-0 314 481.

Jusqu'à présent, cette opération de déverminage des modules était réalisée en plaçant ceux-ci dans une étuve ventilée dont la température était globalement régulée, de façon classique, par un dispositif thermostatique.

Cette manière de procéder de l'art antérieur avait cependant l'inconvénient de présenter une hétérogénéité importante de la température dans le cas de modules ayant une dissipation propre importante (au-delà de 10 W). Ainsi, les différents modules disposés dans l'étuve subissaient des contraintes thermiques variables, insuffisantes ou excessives selon le cas.

Cet inconvénient est en outre accentué dans le cas d'un déverminage dynamique, c'est-à-dire dans lequel on commence par faire fonctionner pendant une première période le module avec une dissipation modérée puis dans un second temps à dissipation minimale. Compte tenu du fait que les modules n'ont pas tous été placés dans l'étuve au même moment, et n'ont donc pas commencé leur cycle de déverminage simultanément, on trouvera dans l'étuve à la fois des modules en régime de faible dissipation et d'autres en régime de forte dissipation, ce qui accentuera encore les écarts de température dans l'enceinte de l'étuve, ce qui va à l'encontre de la fonction première de celle-ci.

L'un des buts de l'invention est de proposer une étuve permettant, comme on souhaite le réaliser, d'effectuer le déverminage de lots importants de modules (plusieurs dizaines ou plusieurs centaines simultanément) tout en uniformisant la contrainte thermique subie par chacun des modules.

Un autre but de l'invention est de proposer une structure d'étuve de déverminage qui permette de réguler individuellement la température sur chaque module, afin que le déverminage de celui-ci ait lieu pour tous exactement dans les mêmes conditions.

Essentiellement, le principe de l'invention consiste à plaquer sur le radiateur de refroidissement de chaque module un bloc chauffant lui-même pourvu d'un peigne mâle épousant la forme du radiateur du module, la face extérieure du bloc chauffant étant elle-même équipée d'un radiateur dont la capacité de dissipation est choisie, par construction, de manière à être toujours supérieure aux besoins du module.

On pourra réaliser une régulation locale, module par module, qui ne soit pas dépendante de l'uniformité de température à l'intérieur de l'étuve.

En effet, comme il y aura toujours régulation (qu'il faille apporter ou retirer de la chaleur au module), l'élément chauffant contrôlé compensera la quantité de chaleur plus ou moins importante que pourra dissiper le radiateur du bloc compte tenu de la température locale de l'ambiance dans laquelle il se trouve, c'est-à-dire de la température locale de l'enceinte.

Plus précisément, l'étuve de la présente invention permettant d'atteindre ces avantages comporte, pour chaque module, des circuits d'alimentation électrique contrôlée de ce module, ainsi que des moyens localement commandés de régulation de la température par un dissipateur contrôlable, ce dissipateur contrôlable comprenant lui-même :
- un bloc dérivateur de chaleur, comportant:
   · un corps, conducteur de la chaleur,
   · des moyens de chauffage du corps de bloc,
   · des moyens de mise en contact de ces moyens de chauffage avec le radiateur du module, de manière à faire coopérer thermiquement ceux-ci par la conduction résultant de ce contact, et
   · un radiateur de refroidissement, propre à dissiper de la chaleur du corps de bloc vers une ambiance extérieure,
   les dimensions et la géométrie de ce radiateur du bloc, ainsi que les conditions de température et de ventilation de ladite ambiance extérieure, étant choisies de manière à pouvoir extraire du bloc, par le radiateur de celui-ci, une quantité de chaleur supérieure à la quantité de chaleur dissipée par le radiateur du module,
- des moyens de mesure de la température du module, et
- des moyens de commande desdits moyens de chauffage, ces moyens opérant en réponse à un signal délivré par lesdits moyens de mesure de température de manière à apporter au bloc, par chauffage, une quantité de chaleur permettant, respectivement, d'apporter de la chaleur au module ou de lui en retirer, de manière à réguler la température individuelle du module considéré à une valeur de consigne donnée, respectivement supérieure ou inférieure à celle que présenterait le module hors de contact avec le bloc dérivateur de chaleur.

Elle comporte également, en combinaison avec les moyens précédents et pour l'ensemble des modules, une unité de commande centralisée supervisant, par l'intermédiaire d'un réseau, le fonctionnement des divers modules et de leurs moyens associés, localement commandés, de régulation de température.

Avantageusement, chaque dissipateur contrôlable est réalisé sous forme d'une carte de circuit comportant, sur l'une de ses faces, le bloc dérivateur de chaleur recevant le module et, sur son autre face, les circuits électroniques d'alimentation, de régulation et de test, ces circuits comprenant lesdits circuits de mesure de la température du module, lesdits circuits de commande des moyens de chauffage et des circuits d'alimentation électrique contrôlée du module et de test de celui-ci.

On peut alors prévoir une architecture en réseau, avec au moins un circuit multiplexeur relié à une pluralité desdits circuits électroniques d'alimentation, de régulation et de test, chaque circuit multiplexeur, gérant ainsi une pluralité de modules, étant lui-même relié à une unité de commande centralisée recevant des données en provenance de chaque module, ou émettant des données en direction de celui-ci, via le circuit multiplexeur associé à ce module.

Par ailleurs, lesdits moyens de mise en contact des moyens de chauffage avec le radiateur du module comprennent avantageusement un peigne de conformation homologue de celle des ailettes du radiateur du module, et emboîté dans celles-ci, avec en outre des moyens sollicitant élastiquement le peigne contre les ailettes du radiateur du module, de manière à assurer un contact par pression entre ces deux éléments.

De préférence, lesdits moyens de chauffage du corps de bloc comprennent une résistance plane en film déposée en surface du corps de bloc.

D'autres caractéristiques et avantages de l'invention apparaîtront à la lecture de la description détaillée ci-dessous faite en référence aux dessins annexés sur lesquels les mêmes références numériques désignent des éléments identiques.

La Figure 1 est une vue en plan de l'un des alvéoles de l'enceinte recevant un module à déverminer.

La Figure 2 est une vue générale de face de l'enceinte selon l'invention, permettant le déverminage collectif d'un lot de 100 modules.

La Figure 3 est une vue en élévation, en coupe selon III-III de la Figure 2, de l'enceinte selon l'invention, montrant la circulation de l'air à l'intérieur de celle-ci.

La Figure 4 est une vue en plan, en coupe selon IV-IV de la Figure 2, de cette même enceinte.

La Figure 5 montre la manière dont sont connectées ensemble, pour former un réseau, les différentes cartes électroniques utilisées par l'étuve de l'invention.

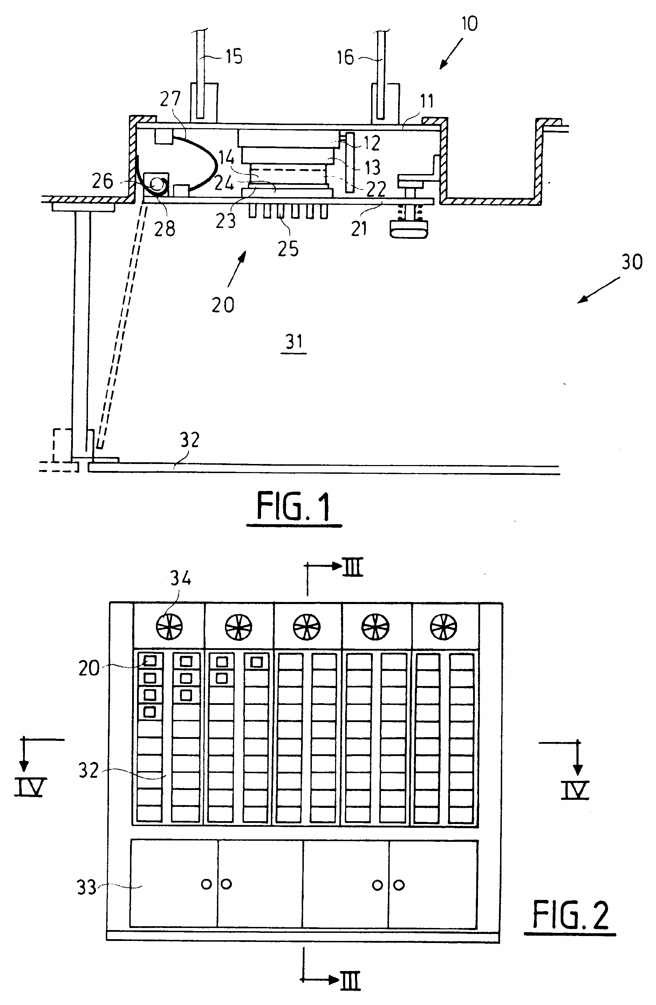

Comme on peut le voir sur la Figure 1, l'enceinte comporte une pluralité de logements formés dans la structure de l'enceinte, et équipés chacun d'un sous-ensemble, propre à chaque module à déverminer, comprenant un circuit 10 constitué d'une carte imprimée 11 portant un support de module 12, de préférence un support à force d'insertion nulle, recevant le module à tester 13 proprement dit enfiché dans ce support; ce module comporte un radiateur de dissipation thermique 14.

Le circuit 10 comporte en outre une carte de commande 15, assurant notamment l'interfaçage avec le réseau de transmission des données ainsi que la régulation, et une carte d'alimentation 16 produisant et distribuant les diverses tensions nécessaires au fonctionnement du module. Il est ainsi prévu un circuit 10 pour chacun des modules à tester.

La régulation proprement dite est exécutée par un bloc 20 monté sur un support mobile 21, comprenant un peigne en alliage léger 22 épousant la forme des ailettes du radiateur 14 du module 13, une résistance 23 et un corps 24, pourvu d'ailettes 25 de dissipation extérieure (ce radiateur étant réalisé en un matériau bon conducteur de la chaleur tel que l'aluminium ou le cuivre).

Le peigne 22, en contact avec le radiateur du module, et le corps 24 du bloc doivent présenter entre eux la plus faible résistance thermique, et pour cette raison on choisit pour la résistance 23, qui est placée en position intercalaire entre ces deux éléments, une résistance très mince, typiquement une résistance déposée sur un film polyester thermoplastique et alimentée en basse tension.

La plaque support 21 est articulée en 26 au bâti de l'étuve de manière à permettre l'accès au module pour la mise en place et le retrait de celui-ci. Il est en outre prévu un moyen élastique tel qu'une lame ressort 27 permettant de maintenir une légère pression du bloc 20 sur le module pour assurer un bon transfert thermique entre ces deux éléments. La plaque support 21 est maintenue ouverte par un ressort de rappel 28 logé dans la charnière 26, ceci afin de ne pas gêner la mise en place et l'extraction des modules.

Comme on peut le voir figures 2 à 4, il est prévu autant de logements et sous-ensembles tels qu'illustrés figure 1 que de modules à tester, et le tout est par exemple rassemblé en une armoire recevant 100 modules répartis en 10 rangées de 10 modules disposés en façade.

Les radiateurs 25 des blocs de régulation des différents sous-ensembles sont tous placés dans une enceinte fermée 30 définissant une ambiance ventilée dans la région 31 (figures 1, 3 et 4).

Des portes transparentes 32 disposées devant les blocs de régulation canalisent verticalement une circulation forcée d'air destinée à évacuer la dissipation thermique des blocs de chauffage et des modules. L'air frais est aspiré en partie basse en 33 par une série de ventilateurs 34 disposés en partie haute de chaque armoire et refoulant l'air ambiant aspiré, réchauffé dans la conduite 31 au contact des radiateurs 25 des différents blocs de régulation, dans une gaine horizontale d'évacuation 35, elle-même raccordée à une gaine d'évacuation vers l'extérieur du local.

On peut également prévoir une ventilation supplémentaire de la région 36 située en arrière des différents blocs de régulation, au moyen d'un ventilateur 37 situé en partie basse, ce qui permet également de refroidir les alimentations principales 38 de l'armoire.

Le principe de régulation de la température des modules est le suivant:
- Lorsque la dissipation propre du module ne suffit pas à élever sa température de jonction jusqu'à la température de contrainte (typiquement 165°C), l'apport complémentaire de chaleur est fourni par la résistance 23.
- En revanche, si la dissipation propre du module est telle qu'il faille refroidir celui-ci, la résistance 23 est utilisé comme dissipateur contrôlable, le radiateur du bloc étant capable d'extraire une quantité de chaleur supérieure à celle que pourrait extraire, seul, le radiateur du module ; en d'autres termes, les ailettes 25 du corps 24 du bloc de régulation assurent un pompage thermique supérieur aux besoins du module, et le complément est apporté par la résistance 23, toujours alimentée, qui assure ainsi la régulation locale, spécifique au module considéré, quelle que soit la température de l'air ambiant.

La température de chaque module est mesure par deux thermo-couples, l'un étant associé à la carte de commande 15 du sous-ensemble pour assurer la régulation de température du module, et l'autre étant relié à un circuit indépendant pour assurer la sécurité de la température du module. Ce dernier circuit assure la linéarisation du signal et compare cette valeur avec un seuil d'alarme réglé manuellement, afin d'entraîner si besoin est la coupure du chauffage et des alimentations par commande d'un relais. Cette chaîne de mesure et de sécurité est totalement indépendante des circuits de régulation de la carte de commande 15.

Grâce à une telle configuration, on a pu obtenir, pour chacun des modules, une régulation de la température de jonction à 250 °C maximum.

Diverses modifications peuvent être apportées au mode de réalisation décrit, par exemple la possibilité de faire du froid avec des éléments Peltier, si l'on souhaite par exemple fonctionner à des températures relativement faibles, typiquement des températures inférieures à 40-50 °C.

Il est également possible, au lieu de faire circuler dans la zone 31 de l'air à température ambiante, d'y faire circuler de l'air refroidi pour améliorer l'extraction thermique.

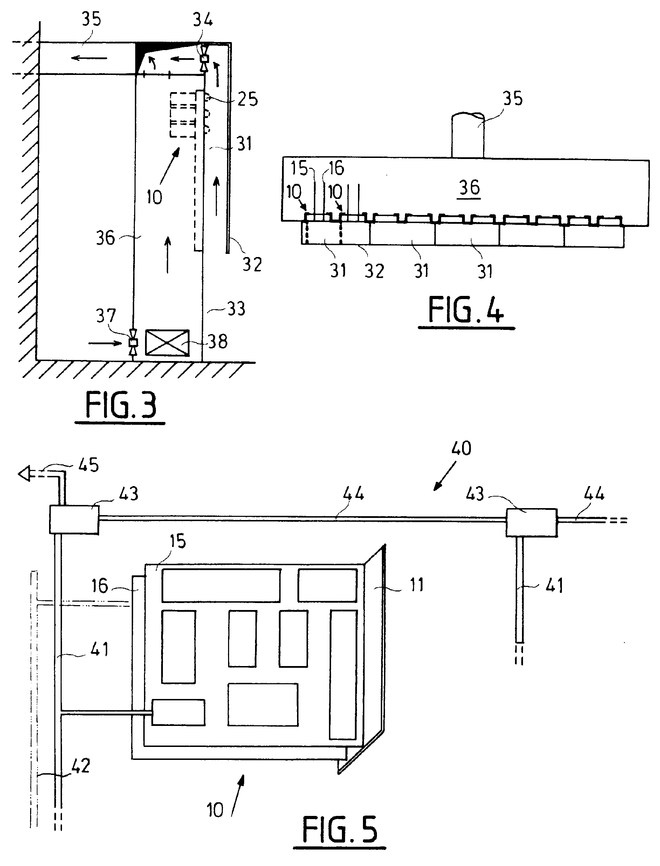

Par ailleurs, les cartes de commande et d'alimentation 15, 16 des différents sous-ensembles sont très avantageusement reliées en réseau, comme illustré figure 5.

Avec une telle architecture en réseau, on peut simplifier le câblage électrique, rendre la maintenance plus facile, maintenir l'autonomie de chaque sous-système et améliorer la fiabilité d'ensemble, puisqu'une panne générale est pratiquement exclue.

Dans un exemple de quatre étuves de cent modules chacune, le réseau est un réseau de quatre cents sous-ensembles 10 (un par module) comportant chacun une carte de commande 15, une carte d'alimentation 16 et une carte support de module 11.

Les différentes cartes de commande 15, par exemple les cartes correspondant à dix sous-ensembles voisins, sont connectés par un bus commun 41 et les cartes d'alimentation 16 sont reliées à une ligne commune 42.

Chacun des bus 41 est relié à un ensemble émetteur/récepteur de réseau 43 assurant le multiplexage des données des sous-ensembles qui lui sont reliées. Ces ensembles 43, reliés entre eux par des bus 44, sont donc au nombre de quarante.

Enfin, un micro-ordinateur est relié au réseau en 45 afin d'assurer la supervision du fonctionnement des quatre cents sous-ensembles 10, tous autonomes.

On peut notamment ainsi, à la demande ou automatiquement:
- afficher à l'écran la valeur des paramètres analogiques de chaque module (tension, intensité, etc),
- modifier la consigne de température, individuellement pour chaque module,
- modifier l'ordre chronologique de montée ou de descente des tensions d'alimentation,
- relever les anomalies de fonctionnement et prendre les décisions correctrices appropriées (par exemple coupure des alimentations en cas de court-circuit sur un module, d'instabilité des tensions ou d'anomalies de température, etc), ou encore
- imprimer systématiquement ou sur demande toutes les informations voulues.

## Revendications

1. Une étuve de déverminage d'un ensemble de modules électroniques, ces modules (13) étant des modules pourvus d'un radiateur de refroidissement (14) dissipant de la chaleur,
caractérisée en ce qu'elle comporte, pour chaque module, des circuits d'alimentation électrique contrôlée de ce module, ainsi que des moyens localement commandés de régulation de la température par un dissipateur contrôlable, ce dissipateur contrôlable comprenant lui-même :
- un bloc dérivateur de chaleur (20), comportant:
· un corps (24), conducteur de la chaleur,
· des moyens (23) de chauffage du corps de bloc,
· des moyens (22, 27) de mise en contact de ces moyens de chauffage avec le radiateur du module, de manière à faire coopérer thermiquement ceux-ci par la conduction résultant de ce contact, et
· un radiateur de refroidissement (25), propre à dissiper de la chaleur du corps de bloc vers une ambiance extérieure,
les dimensions et la géométrie de ce radiateur du bloc, ainsi que les conditions de température et de ventilation de ladite ambiance extérieure, étant choisies de manière à pouvoir extraire du bloc, par le radiateur de celui-ci, une quantité de chaleur supérieure à la quantité de chaleur dissipée par le radiateur du module,
- des moyens de mesure de la température du module, et
- des moyens (15) de commande desdits moyens de chauffage, ces moyens opérant en réponse à un signal délivré par lesdits moyens de mesure de température de manière à apporter au bloc, par chauffage, une quantité de chaleur permettant, respectivement, d'apporter de la chaleur au module ou de lui en retirer, de manière à réguler la température individuelle du module considéré à une valeur de consigne donnée, respectivement supérieure ou inférieure à celle que présenterait le module hors de contact avec le bloc dérivateur de chaleur,
et en ce qu'elle comporte également, pour l'ensemble des modules, une unité de commande centralisée supervisant, par l'intermédiaire d'un réseau, le fonctionnement des divers modules et de leurs moyens associés, localement commandés, de régulation de température.

2. L'étuve de la revendication 1, dans laquelle chaque dissipateur contrôlable est réalisé sous forme d'une carte de circuit (11) comportant, sur l'une de ses faces, le bloc dérivateur de chaleur recevant le module et, sur son autre face, les circuits électroniques d'alimentation (16), de régulation et de test (15), ces circuits comprenant lesdits circuits de mesure de la température du module, lesdits circuits de commande des moyens de chauffage, lesdits circuits d'alimentation électrique contrôlée du module et des circuits de test de celui-ci.

3. L'étuve de la revendication 2, comprenant au moins un circuit multiplexeur (43) relié à une pluralité desdits circuits électroniques d'alimentation (16), de régulation et de test (15), chaque circuit multiplexeur, gérant ainsi une pluralité de modules, étant lui-même relié à ladite unité de commande centralisée recevant des données en provenance de chaque module, ou émettant des données en direction de celui-ci, via le circuit multiplexeur associé à ce module.

4. L'étuve de la revendication 1, dans laquelle lesdits moyens de mise en contact des moyens de chauffage avec le radiateur du module comprennent un peigne (22) de conformation homologue de celle des ailettes du radiateur du module (14), et emboîté dans celles-ci.

5. L'étuve de la revendication 4, dans laquelle lesdits moyens de mise en contact du corps de bloc avec le radiateur du module comprennent en outre des moyens (27) sollicitant élastiquement le peigne contre les ailettes du radiateur du module, de manière à assurer un contact par pression entre ces deux éléments.

6. L'étuve de la revendication 1, dans laquelle lesdits moyens de chauffage du corps de bloc (23) comprennent une résistance plane en film déposée en surface du corps de bloc.

## Patentansprüche

1. Einbrennungsofen für einen Komplex von elektronischen Modulen, wobei diese Module (13) Module sind, die mit einem wärmeableitendem Kühlradiator (14) ausgestattet sind, dadurch gekennzeichnet, daß er für jedes Modul Stromkreise der gesteuerten elektrischen Speisung dieses Moduls, sowie örtlich gesteuerte Einrichtungen für die Temperatureinstellung durch einen steuerbaren Leistungsverbraucher aufweist, wobei dieser steuerbare Leistungsverbraucher selbst aufweist :
- einen Nebenschluß-Wärmeblock (20) mit :
* einem Körper (24), der ein Wärmeleiter ist;
* Heizeinrichtungen (23) des Blockkörpers,
* Einrichtungen (22, 27) zur Kontaktherstellung zwischen diesen Heizeinrichtungen und dem Radiator des Moduls, derart, daß man diese durch die aus diesem Kontakt sich ergebende Leitung wärmetechnisch zusammenwirken läßt und
* einem Kühlradiator (25), der geeignet ist, Wärme von dem Blockkörper an ein Außenmilieu abzuleiten,
wobei die Ausmaße und die Geometrie dieses Radiators des Blocks, sowie die Temperatur- und Belüftungsbedingungen des Außenmilieus derart gewählt werden, daß dem Block durch dessen Radiator eine Wärmemenge entzogen werden kann, die höher ist als die von dem Radiator des Moduls abgeleitete Wärmemenge,
- Meßeinrichtungen für die Temperatur des Moduls, und
- Steuereinrichtungen (15) der Heizeinrichtungen, wobei diese Einrichtungen in Reaktion auf ein von den Meßeinrichtungen der Temperatur geliefertes Signal derart operieren, daß sie dem Block durch Erwärmung eine Wärmemenge zuführen, die erlaubt, dem Modul jeweils Wärme zuzuführen oder zu entziehen, derart , daß die einzelne Temperatur des Moduls, das bei einem gegebenen Einstellwert betrachtet wird, der jeweils oberhalb oder unterhalb demjenigen liegt, den das Modul ohne Kontakt mit dem Nebenschluß-Wärmeblock zeigt, eingestellt wird,
und daß er ebenso für den Komplex von Modulen eine zentralisierte Steuereinheit aufweist, die mittels eines Netzes den Betrieb der verschiedenen Module und ihrer angeschlossenen örtlich gesteuerten Einrichtungen der Temperatureinstellung überwacht.

2. Einbrennungsofen des Anspruchs 1, bei dem jeder steuerbare Leistungsverbraucher in Form einer Leiterplatte (11) ausgeführt ist, die auf einer ihrer Seiten den das Modul aufnehmenden Nebenschluß-Wärmeblock und auf ihrer anderen Seite die elektronischen Stromkreise der Speisung (16), der Einstellung und des Tests (15) aufweist, wobei diese Stromkreise die Meßstromkreise der Temperatur des Moduls, die Steuerstromkreise der Heizeinrichtungen, die Stromkreise der gesteuerten elektrischen Speisung des Moduls und dessen Teststromkreise aufweisen.

3. Einbrennungsofen des Anspruchs 2, der wenigstens einen Multiplexer-Stromkreis (43) aufweist, der mit einer Vielzahl der elektronischen Stromkreise der Speisung (16), der Einstellung und des Tests (15) verbunden ist, wobei jeder Multiplexer-Stromkreis so eine Vielzahl von Modulen steuert, wobei er selbst mit der zentralisierten Steuereinheit verbunden ist, die über den an dieses Modul angeschlossenen Multiplexer-Stromkreis von jedem Modul kommende Daten empfängt, oder Daten in dessen Richtung aussendet.

4. Einbrennungsofen des Anspruchs 1, bei dem die Einrichtungen der Kontaktherstellung zwischen den Heizeinrichtungen und dem Radiator des Moduls einen Kamm (22) der Form aufweisen, die derjenigen der Rippen des Radiators des Moduls (14) entspricht, und der in diese eingelassen ist.

5. Einbrennungsofen des Anspruchs 4, bei dem die Einrichtungen zur Kontaktherstellung zwischen dem Blockkörper und dem Radiator des Moduls außerdem Einrichtungen (27) aufweisen, die den Kamm elastisch gegen die Rippen des Radiators des Moduls spannen, derart, daß ein Kontakt durch Druck zwischen diesen beiden Teilen gewährleistet wird.

6. Einbrennungsofen des Anspruchs 1, bei dem die Heizeinrichtungen des Blockkörpers (23) einen in dünner Schicht ebenen Widerstand auf der Oberfläche des Blockkörpers aufweisen.

## Claims

1. A burn-in oven for a set of electronic modules, these modules (13) being modules having a heat-dissipating cooling radiator (14),
characterised in that it includes, for each module, circuits for the controlled electrical power supply to this module, and locally controlled means for regulating the temperature by means of a controllable dissipator, this controllable dissipator itself comprising:
- a heat-transfer unit (20), including:
. a heat-conducting body (24),
. means (23) for heating the unit body,
. means (22, 27) for bringing these heating means in contact with the module radiator, so as to cause these to interact thermally through the conduction resulting from this contact, and
. a cooling radiator (25), suitable for dissipating heat from the unit body to an external environment,
the dimensions and geometry of this radiator on the unit, and the temperature and ventilation conditions of the said external environment, being chosen so as to be able to extract from the unit, through the radiator on the latter, a quantity of heat greater than the quantity of heat dissipated by the radiator on the module,
- means for measuring the temperature of the module, and
- means (15) for controlling the said heating means, these means operating in response to a signal given by the said temperature-measurement means so as to give to the unit, by heating, a quantity of heat making it possible, respectively, to give heat to the module or take it away from it, so as to regulate the individual temperature of the module in question to a given set value, respectively higher or lower than that which the module would have if it were not in contact with the heat-transfer unit,
and in that it also has, for the set of modules, a centralised control unit monitoring, by means of a network, the functioning of the various modules and their associated locally controlled temperature-regulation means.

2. The oven of Claim 1, in which each controllable dissipator is produced in the form of a circuit board (11) having, on one of its faces, the heat-transfer unit receiving the module and, on its other face, the electronic power supply (16), regulation and test (15) circuits, these circuits comprising the said circuits for measuring the temperature of the module, the said circuits for controlling the heating means, the said controlled electrical power supply circuits for the module and the test circuits for the latter.

3. The oven of Claim 2, comprising at least one multiplexing circuit (43) connected to a plurality of the said electronic power supply (16), regulation and test (15) circuits, each multiplexing circuit, thus managing a plurality of modules, being itself connected to the said centralised control unit receiving data coming from each module, or transmitting data to the latter, via the multiplexing circuit associated with this module.

4. The oven of Claim 1, in which the said means for bringing the heating means into contact with the module radiator comprise a comb (22) with a conformation homologous to that of the fins of the module radiator (14), and fitted into these.

5. The oven of Claim 4, in which the said means for bringing the unit body into contact with the module radiator also comprise means (27) elastically pushing the comb against the module radiator fins, so as to provide contact by pressure between these two components.

6. The oven of Claim 1, in which the said means for heating the unit body (23) comprise a plane resistance made from film deposited on the surface of the unit body.
